# FASCICULE DE BREVET EUROPEEN

(11) **EP 0 598 670 B1**
(45) Date de publication et mention de la délivrance du brevet: **05.09.2001**
(21) Numéro de dépôt: 93440089.6
(22) Date de dépôt: 04.11.1993
(51) Int. Cl.: G01R 33/38

(54) **Dispositif de commutation et procédé de commande mettant en oeuvre ledit dispositif**
Schalt-Anordnung und Steuerungs-Verfahren zur Ausführung einer solchen Anordnung
Switching apparatus and control method for carrying out this apparatus

(30) Priorité: 16.11.1992 FR 9213880
(43) Date de publication de la demande: 25.05.1994
(73) Titulaire: BRUKER SA, 67160 Wissembourg (FR)
(72) Inventeur: Tyburn, Jean-Max, F-67160 Wissembourg (FR); Niess, Alfred, F-67250 Hunspach (FR); Gianotti, Tonio, D-6900 Heidelberg (FR)
(74) Mandataire: Nuss, Pierre

(56) Documents cités:
- EP-A- 0 109 633
- EP-A- 0 227 411
- EP-A- 0 250 718
- EP-A- 0 547 917
- WO-A-85/04258
- US-A- 4 437 053
- J. CHEM. SOC. FARADAY TRANS., vol. 86, no. 19 , 7 Octobre 1990 , CAMBRIDGE, GB pages 3181 - 3184 M. SUEKI ET AL. 'SPECTRAL-SPATIAL ELECTRON PARAMAGNETIC RESONANCE IMAGING OF ELECTROCHEMICALLY GENERATED RADICALS'
- JOURNAL OF MAGNETIC RESONANCE. vol. 94, no. 2 , 1 Septembre 1991 , ORLANDO, MN US pages 370 - 375 M.S. CONRADI ET AL. 'GENERATION OF SHORT, INTENSE GRADIENT PULSES'

## Description

La présente invention concerne le domaine des appareils à résonance magnétique nucléaire (RMN), utilisés notamment en imagerie médicale ou en micro imagerie RMN haute résolution, et a pour objet un dispositif de commutation, ainsi qu'un procédé de commande mettant en oeuvre ledit dispositif.

Actuellement, les nouvelles expériences de RMN à haute résolution nécessite la génération de gradients de champ de forte valeur, à savoir d'environ 10⁻² T/cm (100 Gauss/cm).

Par ailleurs, l'observation de spectres avec une résolution élevée, par exemple inférieure à 0,2 Hz pour un champ principal B1 de 14,6 Tesla et une fréquence de résonance proton de 600 MHz, nécessite la génération de gradients de correction de champ local, au moyen, par exemple pour un spectromètre RMN haute résolution, de bobines de correction, également appelées bobines de "shim".

La valeur typique maximum de ces corrections de champ local est d'environ 10 mGauss et la sensibilité du shim dans une direction, telle que la direction Z, est d'environ 10⁻⁹ T/A (10*µ* Gauss/A).

Par conséquent, le rapport entre le gradient de champ nécessaire pour les expériences à haute résolution et le plus petit gradient influençant le champ est de 10⁻² T / 10⁻¹⁰ T (100 Gauss/1 *µ*Gauss) soit 10⁸.

Or, la valeur du courant délivré par l'amplificateur de sortie du générateur alimentant la bobine destinée à créer le gradient de champ de 10⁻² T/cm (100 Gauss/cm) est d'environ 10A.

Il faudrait donc, pour qu'il n'y ait pas de perturbations néfastes du champ local, que le générateur présente une stabilité, au niveau de son amplificateur de sortie, une stabilité supérieure à 10 A/10⁸ soit 0,1*µ*A.

Une telle stabilité ne peut être atteinte actuellement par des moyens électroniques classiques.

Le problème posé à la présente invention consiste donc à concevoir un dispositif simple et peu coûteux pour éliminer l'influence du bruit de sortie d'un générateur alimentant une bobine de génération de gradients de fortes valeurs sur la stabilité du champ magnétique d'un aimant d'un appareil à RNM, lors des phases de mesure d'une expérience RMN.

Par le document EP-A-0 250 718, on connaît un système d'alimentation d'une bobine de gradient comprenant un dispositif de commande et de réglage du champ produit agissant par l'intermédiaire de moyens interrupteurs.

Ces derniers sont structurés en deux ensembles distincts, à savoir, d'une part, un ensemble formant un dispositif de branchement par étage des différentes composantes d'une alimentation étagée et, d'autre part, un dispositif de commutation de tension aux bornes de la bobine de gradient concerné.

Toutefois, ce document n'évoque en aucune manière le problème posé précité, ni a fortiori n'indique une solution à ce dernier.

Or, le dispositif objet de la revendication 1 annexé et le procédé objet de la revendication 2 annexé permettent justement de résoudre le problème précité.

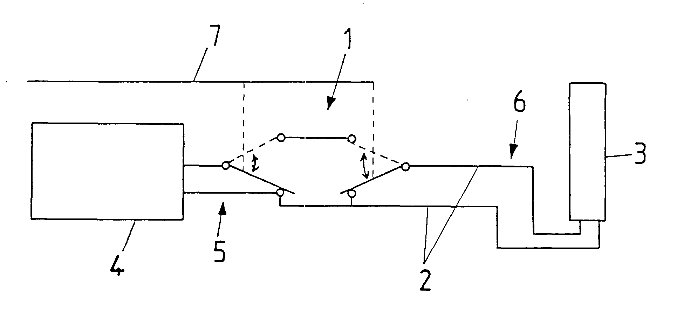

L'invention sera mieux comprise grâce à la description ci-après, qui se rapporte à un mode de réalisation préféré, donné à titre d'exemple non limitatif, et expliqué avec référence au dessin annexé dont la figure unique représente de manière schématique un circuit d'alimentation comprenant le dispositif de commutation selon l'invention.

Comme le montre cette figure du dessin annexé, le dispositif de commutation se présente sous la forme d'un moyen interrupteur 1 monté dans le circuit d'alimentation 2 de la bobine 3, actionné par l'intermédiaire d'un signal de commande et pouvant, en position ouverte, isoler totalement la bobine 3 du générateur 4.

Conformément à un mode de réalisation préféré de l'invention, le dispositif de commutation se présente sous la forme d'un interrupteur double 1 pouvant fractionner, à l'ouverture, le circuit d'alimentation 2 en une portion 5 bouclée sur le générateur 4 et en une portion 6 bouclée sur la bobine 3, indépendantes entre elles.

Lorsque l'interrupteur double 1, éventuellement constitué par l'association de deux interrupteurs simples en série, est commandé à l'ouverture par l'intermédiaire d'une ligne de commande 7, il shunte, par conséquent, le générateur 4 et la bobine 5, isolant ainsi complètement les deux éléments.

Selon une autre caractéristique de l'invention, le dispositif de commutation 1 peut consister avantageusement en un interrupteur ultra-rapide comprenant au moins un transistor à effet de champ, permettant d'obtenir les temps de réaction très courts nécessaires pour passer efficacement de la phase d'excitation à la phase de mesure au niveau de l'appareil à RMN.

L'invention a également pour objet un procédé de commande de l'action d'une bobine 3 destinée à créer un gradient de champ magnétique, notamment de valeur élevée, et alimentée par un générateur 4 de courant ou de tension, mettant en oeuvre le dispositif de commutation 1 décrit ci-dessus.

Ce procédé consiste essentiellement, à la fin de la phase d'excitation et juste avant la phase de mesure, à envoyer un signal d'ouverture au dispositif de commutation 1 de manière à déconnecter et à isoler entre eux le générateur 4 et la bobine 3, et, ensuite, après une durée prédéterminée, à déclencher la phase de mesure.

Bien entendu, l'invention n'est pas limitée au mode de réalisation décrit et représenté au dessin annexé. Des modifications restent possibles, notamment du point de vue de la constitution des divers éléments, ou par substitution d'équivalents techniques, sans sortir pour autant du domaine de protection de l'invention.

## Revendications

1. Appareil de RMN comprenant un aimant destiné à créer un champ magnétique principal B1 et au moins une bobine (3) de génération de gradients de champ magnétique, le circuit d'alimentation (2) de ladite bobine comprenant un générateur (4) de courant ou de tension, appareil **caractérisé en ce qu**'il présente un dispositif de commutation (1) monté dans ledit circuit d'alimentation et comportant des moyens pour être commuté entre une position dans laquelle il relie le générateur (4) et la bobine (3) et une position où, pendant une phase de mesure du signal de RMN, il fractionne ledit circuit d'alimentation en une portion (5) bouclée sur le générateur et une portion (6) bouclée sur la bobine de manière à isoler ladite bobine dudit générateur.

2. Procédé de commande de l'action d'une bobine destinée à créer un gradient de champ magnétique, alimentée à travers un circuit d'alimentation par un générateur de courant ou de tension et faisant partie de l'appareil de RMN selon la revendication 1, procédé **caractérisé en ce qu**'il consiste, à la fin de la phase d'excitation et avant la phase de mesure, à envoyer un signal d'ouverture à un dispositif de commutation (1) monté dans le circuit d'alimentation (2) de manière à déconnecter et à isoler électroniquement entre eux le générateur (4) et la bobine (3), et à fractionner le circuit d'alimentation (2) en une portion (5) bouclée sur le générateur (4) et une portion (6) bouclée sur la bobine (3) et, ensuite, après une durée prédéterminée, à déclencher la phase de mesure.

## Patentansprüche

1. NMR-Vorrichtung mit einem Magneten zum Erzeugen eines Haupt-Magnetfeldes B1 und mindestens einer Spule (3) zum Erzeugen von Magnetfeldgradienten, wobei die Speiseschaltung (2) der Spule einen Strom- oder Spannungs-Generator (4) aufweist, **dadurch gekennzeichnet**, dass die Vorrichtung eine Schaltvorrichtung (1) aufweist, die in der Speiseschaltung montiert ist und Mittel aufweist zum Umschalten zwischen einer Position, in welcher sie den Generator (4) und die Spule (3) verbindet, und einer Position, in welcher sie während einer Messphase des NMR-Signals diese Speiseschaltung in einen Abschnitt (5), welcher an dem Generator kurzgeschlossen ist, und einen Abschnitt (6) unterteilt, welcher dergestalt an der Spule kurzgeschlossen ist, dass diese Spule von dem Generator isoliert ist.

2. Verfahren zur Steuerung einer Spule zum Erzeugen eines Magnetfeldgradienten, welcher über eine Speiseschaltung von einem Strom- oder Spannungsgenerator gespeist wird und Teil der NMR-Vorrichtung bildet gemäß Anspruch 1, **dadurch gekennzeichnet**, dass zum Ende der Anregungsphase und vor der Messphase ein Öffnungssignal an eine Schaltvorrichtung (1) gesendet wird, welche in der Speiseschaltung (2) dergestalt angeordnet ist, dass sie den Generator (4) und die Spule (3) trennt und elektronisch isoliert, und die Speiseschaltung (2) in einen Abschnitt (5), welcher an dem Generator (4) kurzgeschlossen ist und einen Abschnitt (6), welcher an der Spule (3) kurzgeschlossen ist, trennt, und danach nach einer vorbestimmten Dauer die Messphase ausgelöst wird.

## Claims

1. NMR apparatus comprising a magnet for creating a main magnetic field B1 and at least one coil (3) for generating magnetic field gradients, the supply circuit (2) of said coil having a current or voltage generator (4), which apparatus is **characterised in that** it has a switching device (1) mounted in said supply circuit and comprising means for being switched between a position in which it connects the generator (4) and the coil (3) and a position where, during an NMR signal measuring phase, it splits said supply circuit into a portion (5) looped to the generator and a portion (6) looped to the coil in such a way as to insulate said coil from said generator.

2. Method of controlling the action of a coil for creating a magnetic field gradient, supplied via a supply circuit by a current or voltage generator and being part of the NMR apparatus according to claim 1, which method is **characterised in that** it consists, at the end of the excitation phase and before the measuring phase, of transmitting an opening signal to a switching device (1) mounted in the supply circuit (2) in such a way as to electronically disconnect and insulate from one another the generator (4) and the coil (3), and to split the supply circuit (2) into a portion (5) looped to the generator (4) and portion (6) looped to the coil (3) and, then, following a predetermined time period, to trigger the measuring phase.
